# EUROPEAN PATENT APPLICATION

(11) **EP 3 564 974 A1**
(43) Date of publication of application: **06.11.2019**
(21) Application number: 19168478.6
(22) Date of filing: 10.04.2019
(51) Int. Cl.: H01F 27/02, H01F 27/06

(54) **FLEXIBLE FOLDING PRINTED INTERCONNECT FOR REDUCING SIZE OF A SURFACE MOUNTABLE MAGNETIC COMPONENT FOR MEDICAL IMPLANTABLE DEVICES**

(30) Priority: 27.04.2018 US 201862663281 P; 16.05.2018 US 201862672068 P
(71) Applicant: BIOTRONIK SE & Co. KG, 12359 Berlin (DE)
(72) Inventor: Britton, Steven, Tigard OR 97223 (US); Benson, Jonathan M., West Linn, OR 97068 (US)
(74) Representative: Keck, Hans-Georg

(57) **Abstract**

The present invention relates to a transformer assembly (1), comprising: an electrical transformer (2), the transformer (2) comprising a wound coil (3), wherein the coil comprising at least one primary wire (100) having two ends (101, 102), and at least one secondary wire (200) having two ends (201, 202), the wires (100, 200) are wound to form at least one primary winding (10) as well as at least one secondary winding (20) of the transformer (2), and a substrate (4, 4') for carrying the transformer (2), wherein the substrate (4) comprises a main part (40, 40') as well as at least one outer part (41, 41', 42), wherein the main part (40, 40') carries the transformer (2) and the at least one outer part (41, 41', 42) of the substrate (4, 4') is hinged to the main part (40, 40') and is pivoted towards the transformer (2). Further, the present invention relates to a method for producing a transformer assembly.

## Description

The invention relates to a transformer assembly and a method for producing such an assembly.

Miniaturization of all components, including magnetics is required to remain competitive in the implantable medical device industry. Particularly, transformers are one of the largest components in implantable cardioverter-defibrillators (ICD) and are therefore important in any miniaturization effort. PCB-mounted transformers are typically large devices and one of the major reasons for this is that ends of the wires used in the windings are routed long distances to pins or other discrete connectors which also take up significant space. Particularly, wire wrapping around terminations and wire routing often requires valuable space in the X and Y directions. Further, when large terminations are present, it becomes difficult to automatically wind around the bobbin of the transformer.

Thus, based on the above, the problem to be solved by the present invention is to provide a transformer assembly as well as a method for proving such an assembly that is improved regarding installation space.

This problem is solved by a transformer assembly having the features of claim 1 as well as by a method having the features of claim 13. Embodiments of these aspects of the present invention are stated in the corresponding sub claims and are described below.

According to claim 1, a transformer assembly is disclosed, comprising: an electrical transformer, the transformer comprising a wound coil, wherein the coil comprising at least one primary wire having two ends, and at least one secondary wire having two ends, the wires are wound around one single axis to form at least one primary winding (10) as well as at least one secondary winding of the transformer, a substrate for carrying the transformer, wherein the substrate comprises a main part as well as at least one outer part, wherein the main part carries the transformer and the at least one outer part of the substrate is hinged to the main part and is pivoted towards the transformer, and wherein each end of the at least one primary wire and each end of the at least one secondary wire is electrically connected to an assigned primary or secondary contact arranged on the at least one outer part.

Thus, due to the invention, the wires do not need careful routing to the bottom of the bobbin for wire wrapping or connection or termination. Furthermore, particularly, the wires can be terminated immediately upon exiting the primary and secondary winding of the wound coil.

Particularly, according to an embodiment of the transformer assembly according to the present invention, the at least one outer part of the substrate comprises a contact device like a slot, a hole or a contact pad assigned to each primary or secondary contact of the at least one outer part of the substrate for electrically contacting the respective end of the at least one primary wire and/or for electrically contacting the respective end of the at least one secondary wire.

Further, according to an embodiment of the transformer assembly according to the present invention, the ends of the primary wire and/or the ends of the secondary wire are soldered or brazed or welded to the respective associated contact on the respective outer part of the substrate.

Further, according to an embodiment of the transformer assembly according to the present invention, each of said parts of the substrate is formed as a printed circuit board, wherein the at least one outer part is hinged to the main part via a flexible member. Particularly, said flexible members can be flex cables or flex printed circuit boards that comprise sufficient flexibility so that they can be bent in order to pivot the outer parts of the substrate (e.g. PCB) towards the transformer.

Particularly, according to an embodiment, the at least one outer parts of the substrate is pivoted towards the transformer such that they enclose an approximate right angle, preferably in the range of 80° to 100° with the main part of the substrate.

Further, according to an embodiment of the transformer assembly according to the present invention, a conductor (e.g. conducting path, particularly PCB track) extends from each primary and secondary contact of the at least one outer part of the substrate to associated first and second contacts arranged on the main part of the substrate, particularly via said flexible member forming a hinge between the at least one outer part and the main part of the substrate, wherein the respective first contacts arranged on the main part of the substrate are configured for making electrical contact with the at least one primary wire and/or the respective second contacts arranged on the main part of the substrate are configured for making electrical contact with the at least one secondary wire.

In an example, where the substrate has a main part and a first and a second outer part a conductor (e.g. conducting path, particularly PCB track) extends from each primary and secondary contact of the first outer part to an associated first contact arranged on the main part of the substrate, particularly via said flexible member forming a hinge between the first outer part and the main part of the substrate, wherein the respective first contact arranged on the main part of the substrate is configured for making electrical contact with the at least one primary wire, preferably with the ends of the at least one primary wire.

Likewise, according to an embodiment of the transformer assembly according to the present invention, a conductor (e.g. conducting path, e.g. PCB track) extends from each primary and secondary contact of the second outer part to an associated second contact arranged on the main part of the substrate, particularly via said flexible member forming a hinge between the second outer part and the main part of the substrate, wherein the respective second contact arranged on the main part of the substrate is configured for making electrical contact with the at least one secondary wire, preferably with the ends of the at least one secondary wire.

Further, according to an embodiment of the transformer assembly according to the present invention, the first and second contacts of the main part of the substrate are arranged on a bottom side of the main part, which bottom side faces away from the transformer.

Particularly, the first and second contacts of the main part of the substrate are formed as Land Grid Array (LGA). Thus, the first and second contacts of the main part of the substrate preferably form a (e.g. standard) surface mount component configuration, such as LGA or pins. Other contact techniques may also be employed.

Further, according to an embodiment of the transformer assembly according to the present invention, the assembly comprises at least one retention element for connecting the wound coil to the at least one outer part of the substrate so as to maintain the pivoted state of the at least one outer part.

Further, according to an embodiment of the transformer assembly according to the present invention, the transformer assembly comprises an external clip member to maintain the pivoted state of the at least one outer part of the substrate. Said retention element(s) or said separate external clip thus help to maintain the overall shape, reduce the footprint further, and reduce tension on the wires.

Further, according to an embodiment of the transformer assembly according to the present invention, the transformer comprises a core. Particularly, the core is a magnetic core and/or extends through a central opening wound coil.

Yet another aspect of the present invention relates to a method for producing a transformer assembly according to the present invention, wherein the method comprises the steps of:
- providing an electrical transformer, the transformer comprising a wound coil, the wound coil is comprising at least a primary wire comprising two ends, and at least one secondary wire comprising two ends, which wires are wound to form at least one primary winding as well as at least one secondary winding of the transformer,
- providing a substrate for carrying the transformer, wherein the substrate comprises a main part as well as at least one outer part, whereby the at least one outer part is hinged to the main part of the substrate,
- arranging the transformer on the main part of the substrate,
- pivoting the at least one outer part of the substrate upwards and towards the transformer,
- electrically connecting each end of the at least one primary wire and each end of the at least one secondary wire to an associated contact arranged on the at least one outer part of the substrate.

Further, according to an embodiment of the method according to the invention, the step of electrically contacting each end of the at least one primary wire to an associated primary contact arranged on one of the at least one outer part (first outer part) comprises arranging the respective end in, on or at an associated contact device like a slot, a hole or a contact pad assigned to the primary contact, which associated contact device is preferably formed in the first outer part of the substrate, particularly at an upper edge of the pivoted first part of the substrate.

Further, in an embodiment, the step of electrically contacting each end of the at least one secondary wire to an associated secondary contact arranged on one of the at least one outer part (second outer part) comprises arranging the respective end in, on or at an associated contact device like a slot, a hole or a contact pad, which associated contact device is preferably formed in the second outer part of the substrate, particularly at an upper edge of the pivoted second part of the substrate.

Further, in an embodiment, the step of electrically contacting each end of the at least one primary wire to its associated primary contact arranged on the first outer part comprises soldering the respective end to its associated contact device on the first outer part of the substrate.

Further, according to an embodiment, the step of electrically contacting each end of the at least one secondary wire to its associated secondary contact arranged on the second outer part comprises soldering the respective end to its associated contact device on the second outer part of the substrate.

Particularly, according to an embodiment, the step of providing an electrical transformer further comprises mounting the wound coil on a core, particularly such that the core extends through a central opening of the wound coil.

Further, in an embodiment, after pivoting of the at least one outer parts of the substrate, the outer parts of the substrate are affixed and/or connected to the wound coil.

In all embodiments, the wound coil can be a bobbin coil, which is known from the art.

Due to the present invention, the overall size of the transformer assembly can be reduced. Further, the invention allows the use of standard terminations on the board (e.g. LGA or BGA).

Furthermore, time and cost for making connections to the windings can be reduced and interconnect reliability is increased since wires no longer travel long distances. Furthermore, the labor processes required for winding and terminating can be designed and optimized for automation.

This invention is also amenable to assembly of multiple transformers arrayed out on an easy to handle PCB with tie-ins to each transformer.

Further features and embodiments of the present invention shall be described below with reference to the Figures, wherein
- Fig. 1: shows a lateral view of a transformer assembly according to a first embodiment of the present invention;
- Fig. 2: shows a top view of the transformer assembly of Fig. 1;
- Fig. 3: shows a plan view onto a bottom side of a main part of a substrate of the transformer assembly shown in Figs. 1 and 2;
- Fig. 4: shows a lateral view of a pivotable second part of the substrate of the transformer assembly;
- Fig. 5: shows a lateral view of a pivotable first part of the substrate of the transformer assembly; and
- Figs. 6 to 11: show a process of producing the assembly shown in Figs. 1 to 5.
- Fig. 12: shows a lateral view of a transformer assembly according to a further embodiment of the present invention;
- Fig. 13: shows a top view of the transformer assembly of Fig. 12;
- Fig. 14: shows a plan view onto a bottom side of a main part of a substrate of the transformer assembly shown in Figs. 12 and 13;

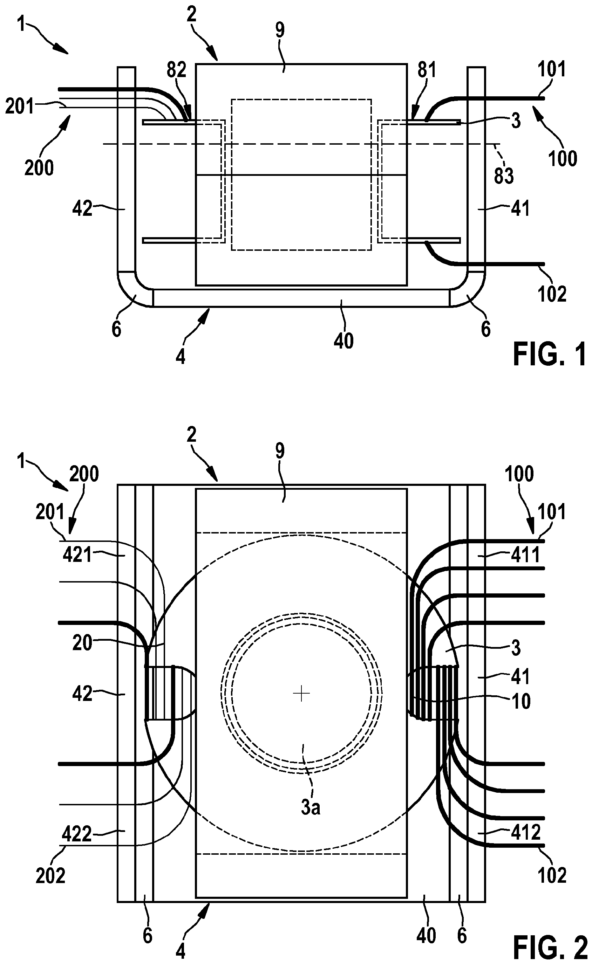

Figure 1 shows in conjunction with Figs. 2 to 5 a transformer assembly 1 according to a first embodiment of the present invention. The assembly 1 comprises an electrical transformer 2 which comprises a bobbin 3 and particularly a core 9 that may be formed out of or comprises a material such as iron, ferrite, silicon steel or another suitable material. The transformer 2 further comprises at least one primary wire 100 comprising two ends 101, 102, and at least one secondary wire 200 comprising two ends 201, 202. Particularly, the transformer 2 may comprise any number and configuration of primary and secondary windings. In the following, for the sake of simplicity, only a primary and a secondary wire 100, 200 are described, which wires are wound on the bobbin 3 to form a corresponding primary and secondary winding 10, 20.

Further, for carrying the transformer 2, the assembly 1 comprises a substrate 4, e.g. a printed circuit board (PCB), wherein the substrate 4 comprises a main part 40 which carries the transformer 2 as well as a first and a second outer part 41, 42, which outer parts 41, 42 of the substrate 4 are hinged to the main part 40 and are pivoted towards the transformer 2 as shown e.g. in Fig. 1, such that the outer parts 41, 42 of the substrate 4 enclose an angle in the range of e.g. 85° to 95° with the main part 40 of the substrate 4. Particularly, for allowing pivoting of the outer parts 41, 42 of the substrate 4 towards the transformer 2, the outer parts 41, 42 are connected to the main part 40 of the substrate 4 via flexible members 6 serving as hinges, respectively.

Due to this pivoted arrangement of the outer parts 41, 42 of the substrate 4, each end 101, 102 of the at least one primary wire 100 as well as each end 201, 202 of the at least one secondary wire 200 can be electrically connected with corresponding primary contacts 411, 412, and secondary contacts 421, 422 (cf. e.g. Figs. 2, 4 and 5) of the first and second outer part 41, 42 of the substrate 4 without routing them longer distances, since the pivotable outer parts 41, 42 of the substrate directly face the transformer 2 and the wire ends 101, 102, 201, 202 protruding from the transformer 2.

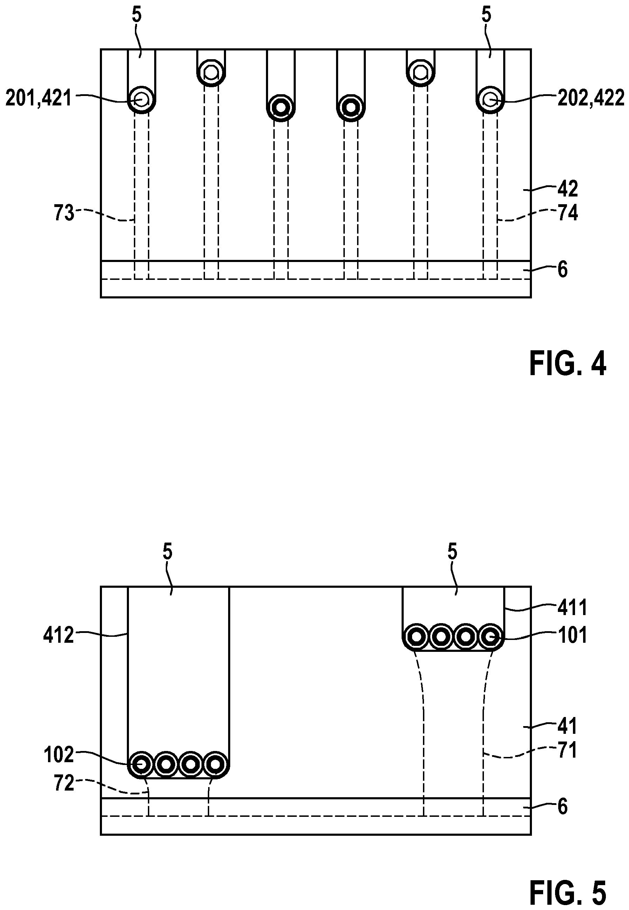

Particularly, as shown particularly in Figs. 4 and 5 the first part 41 of the substrate 4 comprises contact devices in form of a slot 5 assigned to each primary contact 411, 412 of the first part 41 of the substrate 4 for receiving the respective end 101, 102 of the at least one primary wire 100, while the second part 42 of the substrate 4 comprises contact devices in form of a slot 5 assigned to each secondary contact 421, 422 of the second part 42 of the substrate 4 for receiving the respective end 201, 202 of the at least one secondary wire 200.

Particularly each of said parts 40, 41, 42 of the substrate 4 may be formed as a printed circuit board (PCB), wherein the first outer part 41 is hinged to the main part 40 via a flexible member 6 (e.g. a flex PCB), and wherein the second outer part 42 is hinged to the main part 40 via a flexible member 6 (e.g. a flex PCB).

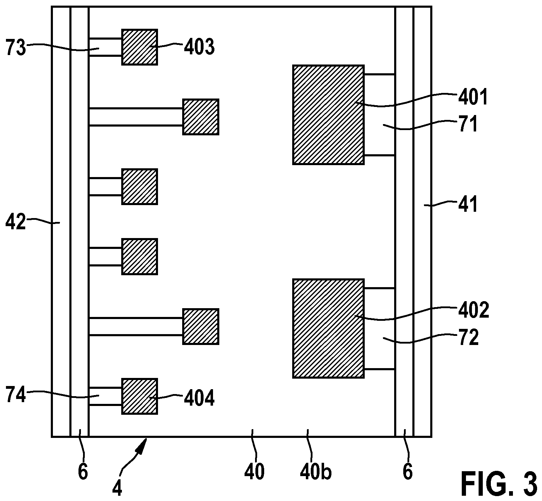

Particularly, as further shown in Fig. 3, 4 and 5, a conductor 71, 72 extends from each primary contact 411, 412 of the first outer part 41 of the substrate 4 to an associated first contact arranged 401, 402 on the main part 40 of the substrate 4, wherein the respective first contact 401, 402 arranged on the main part 40 of the substrate 4 is configured for making electrical contact with the at least one primary wire 100. Likewise a conductor 73, 74 extends from each secondary contact 421, 422 of the second outer part 42 of the substrate 4 to an associated second contact 403, 404 arranged on the main part 40 of the substrate 4, wherein the respective second contact 403, 404 arranged on the main part 40 of the substrate 4 is configured for making electrical contact with the at least one secondary wire 200.

Particularly, as further indicated in Fig. 3, the set of contacts comprising first and second contacts 401, 402, 403, 404 of the main part 40 of the substrate 4 are arranged on a bottom side 40b of the main part 40, which bottom side 40b faces away from the transformer 2. Particularly, the first and second contacts 401, 402, 403, 404 of the main part 40 of the substrate 4 are formed as LGA or BGA pads and are arranged insulated from the transformer 2.

Optionally, as indicated in Fig. 1 the transformer assembly 1 may comprise a first retention element 81 for connecting the bobbin 3 to the first outer part 41 of the substrate 4 as well as a second retention element 82 for connecting the bobbin 3 to the second outer part 42 of the substrate 4. Such retention elements 81, 82 particularly serve for maintaining the pivoted state of the first and second outer part 41, 42. Alternatively, a separate clip member 83 (indicated by a dashed line in Fig. 1) may be used to maintain said pivoted state.

In addition to the outer parts 41 and 42, additional outer parts may be arranged so that after pivoting these additional outer parts the transformer 2 is at least laterally completely encased, preferred completely laterally and on top encased.

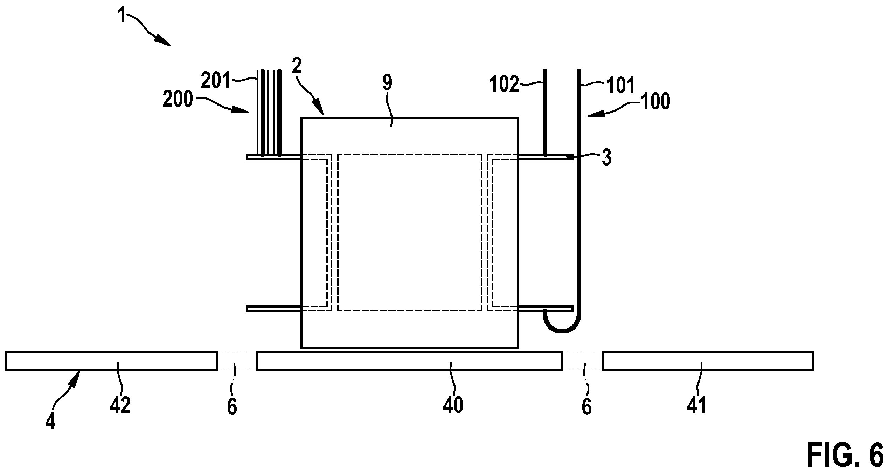

Furthermore, Figs. 6 to 11 show an exemplary embodiment of the method according to the first embodiment of the present invention for producing/wiring a transformer assembly 1.

Here, as shown in Fig. 6, the transformer 2 (having e.g. a bobbin 3, a core 9, and at least a primary and a secondary wire 100, 200 forming a primary and secondary winding 10, 20) may be mounted with a suitable process, which is not part of the invention, to a main part 40 of a substrate 4 of the transformer assembly 1, wherein the main part 40 and the pivotable first and second outer part 41, 42 of the substrate 4 are initially arranged in a flat configuration.

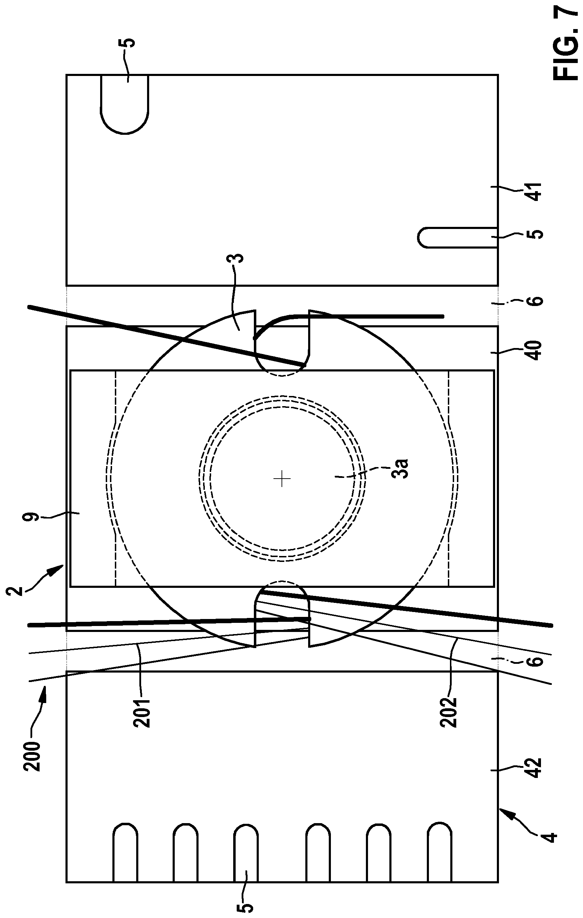

The wire ends 101, 102, 201, 202 are preferably arranged such that they extend upwards and do not interfere with the outer parts 41, 42 when the latter are folded upwards and towards the transformer 2 (cf. Figs. 6 and 7).

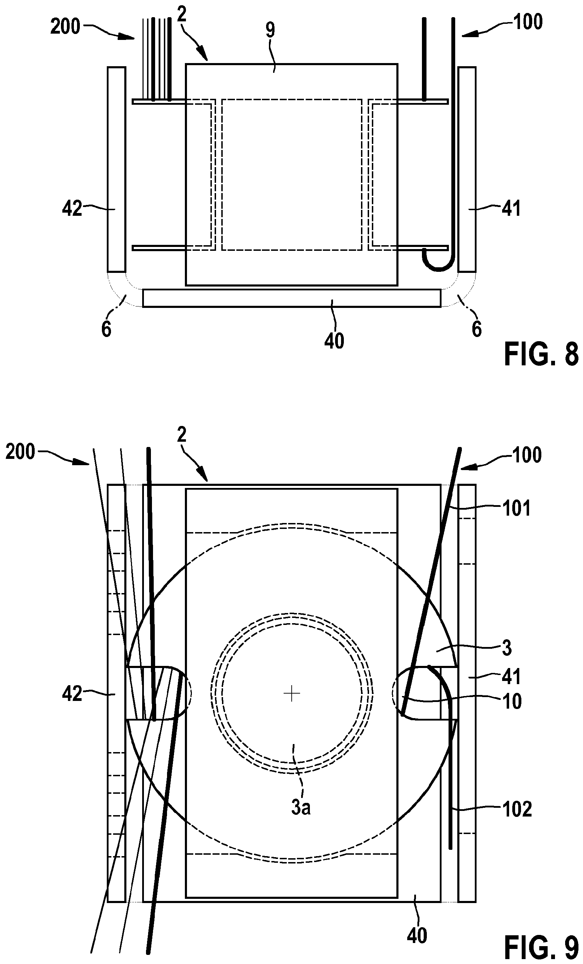

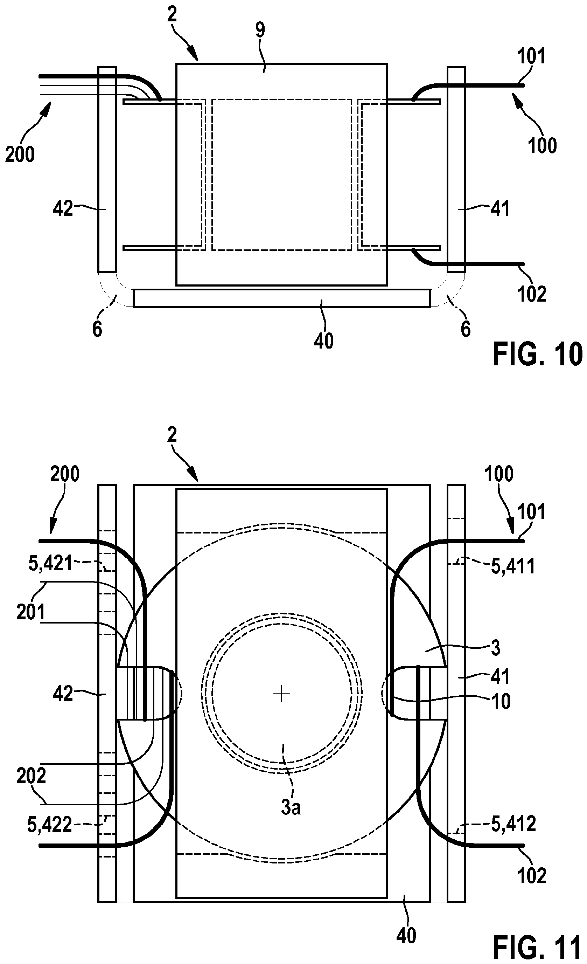

The outer parts 41, 42 of the substrate 4 are then folded upwards and towards one another/towards the transformer 2 as shown in Figs. 8 and 9. Then, as shown in Figs. 10 and 11 the electrical connections between the first wire ends 101, 102 and the contact devices in form of a slot 5, assigned to the primary contacts 411, 412, as well as between the first wire ends 201, 202 and the contact devices in form of a slot 5, assigned to the secondary contacts 421, 422 are established (see also above). The wire ends 101, 102, 201, 202 may be soldered to the respective contacts 411, 412, 421, 422.

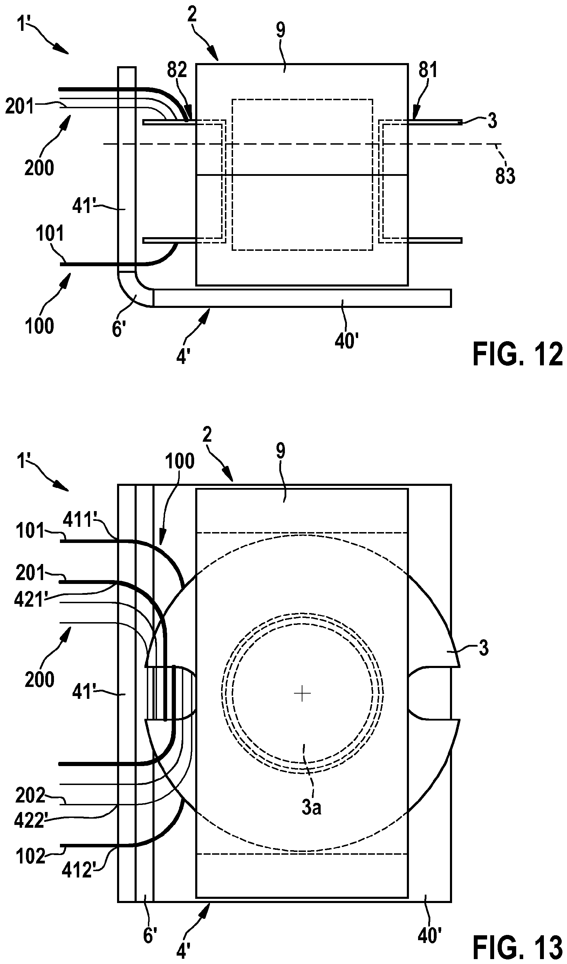

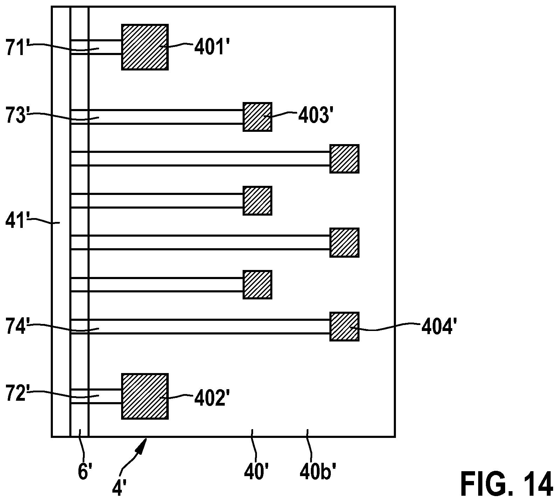

Figure 12 shows in conjunction with Figs. 13 and 14 a transformer assembly 1' according to a further embodiment of the present invention. For all elements, which are identical and/or have the same function as the first embodiment, the references are used accordingly. These functions and elements have been already described and will not be addressed in detail in the description of this further embodiment. Like the first embodiment the assembly 1' comprises an electrical transformer 2 which comprises a bobbin 3 and particularly a core 9 that may be formed out of or comprises a material such as iron, ferrite, silicon steel or another suitable material.

The transformer 2 in this further embodiment is carried by a substrate 4', e.g. a printed circuit board (PCB), wherein the substrate 4' comprises a main part 40' which carries the transformer 2 as well as one outer part 41', which outer part 41' of the substrate 4' is hinged to the main part 40' and is pivoted towards the transformer 2 as shown e.g. in Fig. 12, such that the outer part 41' of the substrate 4' enclose an angle in the range of e.g. 75° to 105° with the main part 40' of the substrate 4'. The outer part 41' is connected to the main part 40' of the substrate 4' via flexible members 6 serving as hinges, respectively.

The transformer 2 further comprises at least one primary wire 100 comprising two ends 101 and 102 (Fig. 13), and at least one secondary wire 200 comprising two ends 201, 202. Because of this unilaterally arranged outer part 41' of the substrate 4', both the at least one primary wire 100 as well as the at least one secondary wire 200 have to be fed out the transformer unilaterally, *i.e.* the side, where the outer part 41' of the substrate 4' is pivoted towards the transformer 2. Each end 101, 102 of the at least one primary wire 100 as well as each end 201, 202 of the at least one secondary wire 200 can be electrically connected with corresponding primary contacts 411', 412', and secondary contacts 421', 422' (cf. e.g. Figs. 13 and 14) of outer part 41', which is again possible, because the pivotable outer part 41' of the substrate 4' directly faces the transformer 2 and the wire ends 101, 102, 201, 202 protruding from the transformer 2. The primary contacts 411', 412' and secondary contacts 421', 422' are configured similarly than already described in respect to Figs. 4 and 5 of the first embodiment above.

Particularly each of said parts 40' and 41' of the substrate 4' may be formed as a printed circuit board (PCB), wherein the first outer part 41' is hinged to the main part 40' via a flexible member 6' (e.g. a flex PCB).

Particularly, as further shown in Fig. 14, a conductor 71', 72' extends from each primary contact 411', 412' of the first outer part 41' of the substrate 4' to an associated first contact arranged 401', 402' on the main part 40' of the substrate 4', wherein the respective first contact 401', 402' arranged on the main part 40' of the substrate 4' is configured for making electrical contact with the at least one primary wire 100. Likewise a conductor 73', 74' extends from each secondary contact 421', 422' of the outer part 41' of the substrate 4' to an associated second contact 403', 404' arranged on the main part 40' of the substrate 4', wherein the respective second contact 403', 404' arranged on the main part 40' of the substrate 4' is configured for making electrical contact with the at least one secondary wire 200.

Particularly, as further indicated in Fig. 14, the set of contacts comprising first and second contacts 401', 402', 403', 404' of the main part 40' of the substrate 4' are arranged on a bottom side 40b' of the main part 40', which bottom side 40b' faces away from the transformer 2. Particularly, the first and second contacts 401', 402', 403', 404' of the main part 40' of the substrate 4' are formed as LGA or BGA pads and are arranged electrically insulated from the transformer 2.

Optionally, as already indicated in Fig. 1, the transformer assembly 1' of this further embodiment may also comprise at least one retention element for securing the bobbin 3 to the outer part 41' of the substrate 4' Such at least one retention elements particularly serve for maintaining the pivoted state of the outer part 41.

All additional configurations of the first embodiments, which are not already mentioned relating to the further embodiment, may be combined in addition.

Furthermore, the method for producing/wiring a transformer assembly 1 according to the first embodiment shown in Figs. 6 to 11 applies to the further embodiment accordingly.

## Claims

1. A transformer assembly (1, 1'), comprising:
- an electrical transformer (2), the transformer (2) comprising a wound coil (3), wherein the coil comprising at least one primary wire (100) having two ends (101, 102), and at least one secondary wire (200) having two ends (201, 202), the wires (100, 200) are wound to form at least one primary winding (10) as well as at least one secondary winding (20) of the transformer (2),
- a substrate (4, 4') for carrying the transformer (2), wherein the substrate (4, 4') comprises a main part (40, 40') as well as at least one outer part (41, 41', 42), wherein the main part (40, 40') carries the transformer (2) and the at least one outer part (41, 41', 42) of the substrate (4, 4') is hinged to the main part (40, 40') and is pivoted towards the transformer (2), wherein
- each end (101, 102) of the at least one primary wire (100) and each end (201, 202) of the at least one secondary wire (200) is electrically connected to an assigned primary or secondary contact (411, 411', 412, 412', 421, 421', 422, 422') arranged on the at least one outer part (41, 41', 42).

2. The transformer assembly according to claim 1, **wherein** the at least one outer part (41, 41', 42) of the substrate (4, 4') comprises a contact device (5) assigned to each primary or secondary contact (411, 411', 412, 412', 421, 421', 422, 422') of the at least one outer part (41, 41', 42) of the substrate (4, 4') for electrically contacting the respective end (101, 102) of the at least one primary wire (100) and/or for electrically contacting the respective end (201, 202) of the at least one secondary wire (200) .

3. The transformer assembly according to claim 1 or 2, **wherein** each of said parts (40, 41, 41', 42) of the substrate (4, 4') is formed as a printed circuit board, wherein the at least one outer part (41, 41', 42) is hinged to the main part (40, 40') via a flexible member (6, 6').

4. The transformer assembly according to one of the preceding claims, **wherein** the at least one outer part (41, 41', 42) of the substrate (4, 4') is pivoted towards the transformer (2) such that they enclose an angle in the range of 80° to 100° with the main part (40, 40') of the substrate (4, 4').

5. The transformer assembly according to one of the preceding claims, **wherein** a conductor (71, 71', 72, 72', 73, 73', 74, 74') extends from each primary and secondary contact (411, 411', 412, 412', 421, 421', 422, 422') of the at least one outer part (41, 41', 42) of the substrate (4, 4') to associated first and second contacts (401, 401', 402, 402', 403, 403', 404, 404') arranged on the main part (40, 40') of the substrate (4, 4'), wherein the respective first contacts (401, 401', 402, 402') arranged on the main part (40, 40') of the substrate (4, 4') are configured for making electrical contact with the at least one primary wire (100) and/or the respective second contacts (403, 403', 404, 404') arranged on the main part (40, 40') of the substrate (4, 4') are configured for making electrical contact with the at least one secondary wire (200).

6. The transformer assembly according to claim 5, **wherein** the first and second contacts (401, 401', 402, 402', 403, 403', 404, 404') of the main part (40, 40') of the substrate (4, 4') are arranged on a bottom side (40b, 40b') of the main part (40, 40'), which bottom side (40b, 40b') faces away from the transformer (2).

7. The transformer assembly according to claim 5 or 6, **wherein** the first and second contacts (401, 401', 402, 402', 403, 403', 404, 404') of the main part (40, 40') of the substrate (4, 4') are formed as Land Grid Array or Ball Grid Array or pins.

8. The transformer assembly according to one of the preceding claims, **wherein** the transformer assembly (1, 1') comprises at least one retention element (81, 82) for connecting the wound coil (3) to the at least one outer part (41, 41', 42) of the substrate (4) so as to maintain the pivoted state of the at least one outer part (41, 41', 42)

9. The transformer assembly according to one of the preceding claims, **wherein** the transformer assembly (1, 1') comprises an external clip member (83) to maintain the pivoted state of the at least one outer part (41, 41', 42) of the substrate (4, 4').

10. The transformer assembly according to one of the preceding claims, **wherein** the transformer (2) comprises a core (9).

11. The transformer assembly according to claim 10, wherein the core (9) is a magnetic core.

12. The transformer assembly according to claim 1, wherein the at least one primary wire (100) and the at least one secondary wire (200) are wound on a bobbin to form the at least one primary winding (10) as well as the at least one secondary winding (20) of the transformer (2) of the wound coil.

13. Method for producing a transformer assembly (1, 1') according to one of the preceding claims, comprising the steps of:
- providing an electrical transformer (2), the transformer (2) comprising a wound coil (3), the wound coil is comprising at least a primary wire (100) comprising two ends (101, 102), and at least one secondary wire (200) comprising two ends (201, 202), which wires (100, 200) are wound to form at least one primary winding (10) as well as at least one secondary winding (20) of the transformer (2),
- providing a substrate (4, 4') for carrying the transformer (2), wherein the substrate (4, 4') comprises a main part (40, 40') as well as at least one outer part (41, 41', 42), whereby the at least one outer part (41, 41', 42) is hinged to the main part (40, 40') of the substrate (4, 4'),
- arranging the transformer (2) on the main part (40, 40') of the substrate (4, 4'),
- pivoting the at least one outer part (41, 41', 42) of the substrate (4, 4') upwards and towards the transformer (2),
- electrically connecting each end (101, 102) of the at least one primary wire (100) and each end of the at least one secondary wire (200) to an associated contact (411, 411', 412, 412', 421, 421', 422, 422') arranged on the at least one outer part (41, 41', 42) of the substrate (4, 4').
